# EUROPEAN PATENT SPECIFICATION

(11) **EP 1 199 740 B1**
(45) Date of publication and mention of the grant of the patent: **09.11.2005**
(21) Application number: 01130669.3
(22) Date of filing: 09.08.1996
(51) Int. Cl.: H01L 21/00

(54) **A method of drying silcion substrates**
Ein Verfahren zum Trocknen von Siliziumsubstraten
Une procédure de sechage de substrats en silicium

(30) Priority: 23.08.1995 DE 19531031
(43) Date of publication of application: 24.04.2002
(62) Divisional of application: 96929234.1
(73) Proprietor: Ictop Entwicklungs GmbH, 95490 Mistelgau (DE)
(72) Inventor: Schellenberger, Wilhelm, 95473 Creussen (DE); Herrmannsdörfer, Dieter, 95489 Mistelgau (DE)
(74) Representative: Körber, Martin Hans

(56) References cited:
- EP-A- 0 385 536
- WO-A-95/08406
- PATENT ABSTRACTS OF JAPAN vol. 012, no. 049 (E-582), 13 February 1988 (1988-02-13) & JP 62 198127 A (SANYO ELECTRIC CO LTD;OTHERS: 01), 1 September 1987 (1987-09-01)
- PATENT ABSTRACTS OF JAPAN vol. 015, no. 229 (E-1076), 11 June 1991 (1991-06-11) & JP 03 066126 A (SHARP CORP), 20 March 1991 (1991-03-20)
- PATENT ABSTRACTS OF JAPAN vol. 017, no. 203 (E-1354), 21 April 1993 (1993-04-21) & JP 04 346431 A (MITSUBISHI ELECTRIC CORP), 2 December 1992 (1992-12-02)

## Description

The invention relates to a procedure for cleanly drying surfaces of materials, such as semiconductors, ceramics, metals, glasses, plastics and, in particular, silicon wafers and laser disks, wherein a substrate is dipped in a liquid bath and its surfaces are dried as it is separated from the liquid, such as by directing a gas over the liquid surface, the gas being soluble in the liquid and lowering the surface tension of the liquid.

When producing microelectronic devices, silicon, which is usually in the form of monocrystalline wafers, is badly contaminated or damaged as a result of cutting, polishing, varnishing or similar procedures. For that reason, the silicon is usually cleaned in multiple steps, which are usually performed in liquid baths.

The different chemical treatments are usually selectively effective for different types of contaminants (i.e., particles, organic coatings, functional organic Si-CR₃ groups or groups of metals, which show similar chemical behavior with each other). The chemical treatments are typically separated by rinsing steps to make the silicon surface free of chemicals and to avoid mixtures of chemicals. Superior water purity is important to minimize the risk of recontamination by metals at pH neutrality.

The silicon is at risk of being recontaminated by contaminants, such as particles or metals, of a type that was removed during a prior phase of the cleaning sequence because of contamination present in subsequent rinsing steps or in chemicals, such as stabilizers for H₂O₂, used in the subsequent cleaning steps. The total cleaning sequence is finished by a drying step.

Many different drying procedures for silicon surfaces are known. These drying procedures include dry spinning by centrifugal forces and drying by solvents like trichlorethanol or methylenechloride. Furthermore, there are drying techniques using hot air, hot water or isopropyl alcohol. One disadvantage of these popular drying procedures is that immense stress is put on the silicon wafer by high mechanical forces. Accordingly, the danger of damaging the edges is high and, moreover, particle generation caused by movements of the silicon wafers relative to the carrier, is possible. In an extreme case, especially with thinner wafers or after thermal treatments, this stress can result in breaking of the wafer, thus destroying the complete drying object and contaminating the surrounding wafers with particles.

The drying procedures can also lead to high operating costs due to the use of expensive chemicals, the disposal of which is necessary. Finally, one disadvantage of all the procedures mentioned above is the danger of metallic recontamination of the cleaned surfaces during the drying process.

Patent Abstracts of Japan, vol. 012, no. 049 (E -582), JP 62-198 127 A discloses a cleaning and drying method in which a wafer is dipped into a fluoric acid liquid in a first step and into a cleaning water tank in a second step.

Patent Abstracts of Japan, vol. 017, no. 203 (E-1354), JP 04-346 431 A discloses a cleaning method in which ammonia water and ozone containing oxygen are jetted together over a substrate surface.

The underlying object of the present invention is therefore to provide a method for drying substrate surfaces according to the preamble of claim 1 which guarantees the maintenance of the degree of purity of the cleaned surfaces and the effective drying of the substrate with a simultaneous cleaning of the surface in a very quick but very effective way.

This object is achieved by a method for drying substrate surfaces according to claim 1.

Advantageous developments of the present invention are specified in the subclaims.

The invention provides procedures for drying surfaces. The procedures of the invention guarantee the purity of the cleaned surfaces and the effective drying of the surface. The invention is applicable to surfaces of many materials, including semiconductors, metals (particularly aluminum), plastics, glasses, and ceramics. The invention is particularly useful for drying and cleaning laser discs and semiconductor silicon wafers. It is to be understood that the invention is, however, useful in drying substrates of any adequate physical form, especially in the form of wafers, plates or discs.

The invention relates to a method of drying a substrate surface wherein the substrate is dipped into and subsequently separated from a liquid bath and a gas mixture is directed over the surface of the substrate after separating the substrate from the liquid bath. For example, a semiconductor silicon wafer can be dipped into an aqueous HF solution with a concentration of between .001 % and 50% and a gas mixture comprising O₂/O₃ is directed over the silicon wafer surface upon removal from the aqueous HF solution.

The invention is now described by reference to the figures in which:
- Fig. 1: shows the removal of a silicon wafer from a bath with an aqueous HF solution by adding an O₂/O₃ gas mixture.
- Fig. 2: shows the removal of a silicon wafer from a bath with an aqueous HF solution without adding O₂/O₃.
- Fig. 3a-3c: shows the chemical processes of the cleaning or hydrophilizing of the silicon surface using the procedure according to the invention.

The gas mixture added over the surface of the HF solution contains O₂/O₃, and nitrogen or a similar gas can be used as a carrier gas. The carrier gas should be chemically inactive with the O₂/O₃ component of the gas mixture.

Suitable gases include air (N₂, O₂, CO₂), CO₂, He, Ne, Ar, Kr, Xe and Rn. The share of O₃ in the O₂/O₃ gas mixture is preferably I mg up to 0.5 g per liter of O₂/O₃ gas mixture. The gas mixture can consist of only O₂/O₃. If a carrier gas is used, however, the share of the O₂/O₃ gas mixture is preferably greater than 10%.

The silicon atoms active on the surface are changed into Si-H and Si-F bondings. The resulting hydrophobic surface character allows drying even at very low temperatures. The pH value < 7 of an aqueous HF solution during drying prevents metallic recontamination. Furthermore, the HF removes metal contamination in the liquid bath, which exists in an oxidized (= ionized) form like Fe, and keeps it in the liquid as metal fluoride complexes. If ozone is added over the surface of the aqueous HF solution in accordance with the first embodiment of the invention, it dissolves partly in the aqueous HF solution and transfers covalently bonded Si-Me combinations to ionic combinations, Me designing metals.

Moreover, when dissolving ozone in the aqueous HF solution, the MARANGONI effect occurs according to the ozone concentration. The silicon surface comes out hydrophilicly from the aqueous HF solution, meaning that it is wettable with water or aqueous solutions.

With the procedure according to the invention, the gas mixture containing O₂/O₃ is directed over the silicon surface only after its drying. Thus, making the silicon surface hydrophilic takes place only after the drying process. The advantage of this procedure is the very quick drying of the silicon.

According to the invention, separating the silicon from the aqueous HF solution can be done either by lifting the silicon out of the HF solution or by down flowing the HF solution, or by a combination of both.

The relative speed of separation between the silicon and the surface of the solution is about 0.1 to about 20 cm/sec and preferably about 0.5 to about 3.0 cm/sec, since the drying can be done very quickly. Furthermore, the aqueous HF solution can contain additives like organic compounds (such as alcohol, isopropyl alcohol and EDTA), organic acids (such as formic acid, acetic acid and citric acid), acids (such as HCl, H₃PO₄, HClO, HClO₂, HClO₃ and HClO₄), surfactants (cationic or anionic) or solid additives like NH₄F, provided they do not destroy the effects explained above and effective cleaning and drying of the silicon remain. Acids are added in the amount of 0% to about 50% weight, organic compounds are added in the amount of 0% to about 80% weight, surfactants are added in the amount of 0% to about 5% weight and solids are added in the amount of 0% to about 50% weight. Specific applications are possible, with which a stronger than mentioned effect or better cleaning and drying can be achieved by adding one or more acids to the aqueous HF solution. Preferred acids are HCl, H₂SO₄ and H₃PO₄ or mixtures thereof. However, any one or more of the acids described above can be added using the ranges listed above. Preferred mixtures of acids are HF/HCl, HF/HCl/H₂SO₄, HF/H₃PO₄, HF/H₃PO₄/HCl, HF/H₃PO₄/H₂SO₄ and HF/H₃ PO₄/HCl/H₂SO₄. Otherwise the HF solution can be skimmed out to a concentration of c=0 (pure water).

Furthermore, enriching or saturating the aqueous HF solution with ozone before dipping the silicon is an advantage, which results in cleaner silicon surfaces. Multiple mono layers of silicon are oxidized and then eroded. Thus, the cleaning is effective even for metals closely beneath the surface (subsurface contamination).

The HF-concentration is preferably between about .01 % and about .1 %. The range can be 0% (pure water) to 90% (concentrated HF).

A stable ozone content comparable with a saturated status can be achieved by continuously supplying the HF solution tank with an O₂/O₃ gas stream (for example, "bubbling"). Other parameters like temperature, concentration of HF and adding of additives (mainly surfactants) have an influence on the ozone content and the saturated status. A successful cleaning and drying procedure can be achieved with a continuous O₂/O₃ gas stream. In a preferred embodiment, the gas stream is in the range of about 50 to about 300 1/h and the ozone generation is in the range of about 10 to about 50 g/h.

An estimated value of the ozone concentration in the HF solution is in the range of 10 to 80 mg/l.

Another advantage of the invention is that the procedure can be carried out in a temperature range between 0 and 100 degrees Celsius, the preferred temperature being 20 to 50 degrees Celsius.

### Example

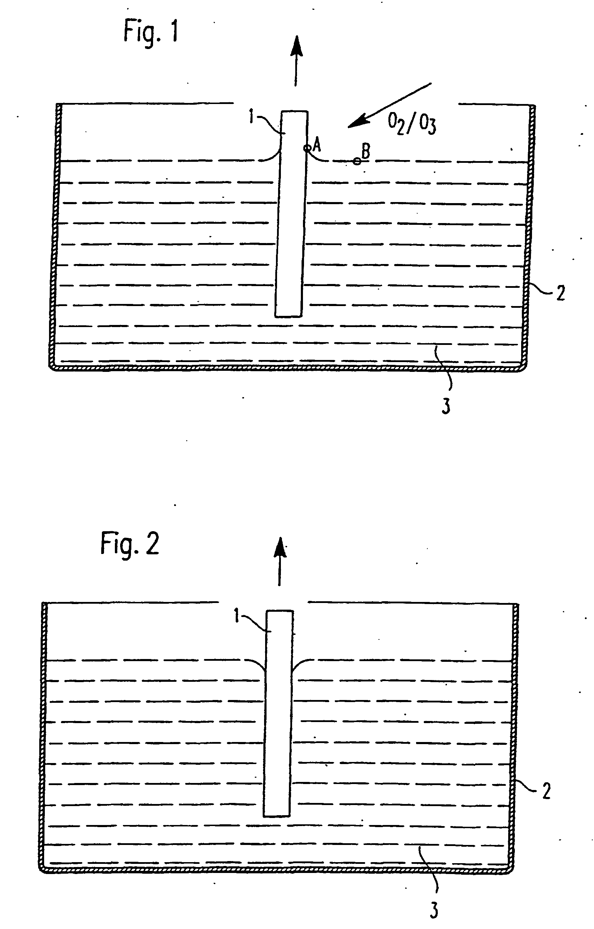

Fig. 1 shows a silicon wafer 1, which is slowly removed from a bath 2 with an aqueous HF solution 3 after being dipped completely into the bath. The direction of removal of the silicon wafer 1 is shown by the arrow pointing vertically upwards over the silicon wafer. The speed of removal is preferably about 3 to about 10 millimeters per second. The arrow diagonal to the silicon wafer surface shows the simultaneous adding of the O₂/O₃ gas mixture over the aqueous solution near the wafer surface.

When slowly removing the silicon wafer 1 from the aqueous HF solution 3, the surface of the aqueous HF solution sticks to the silicon surface, which is bent upwards. This is shown by an upwards curve of the liquid surface at the area between the surface of the solution and the surface of the silicon wafer 1. At point A more ozone is dissolved than at the other places of the surface of the solution, i.e., shown by point B. Since at point A there is a higher ozone concentration than at point B, there is a lower surface tension at point A than at point B. This gradient in the surface tension causes the aqueous HF solution to run from point A to point B, drying the silicon surface.

Fig. 2 shows a silicon wafer 1, which is slowly removed from a bath 2 with an aqueous HF solution 3 after having been dipped completely into the bath. The direction of removal is shown by the arrow pointing vertically upwards over the silicon wafer. Because of the hydrophobicity of the silicon wafer, the surface of the liquid is bent downwards at the silicon surface. The hydrophilizing of the silicon surface by ozone takes place only after the drying process is finished.

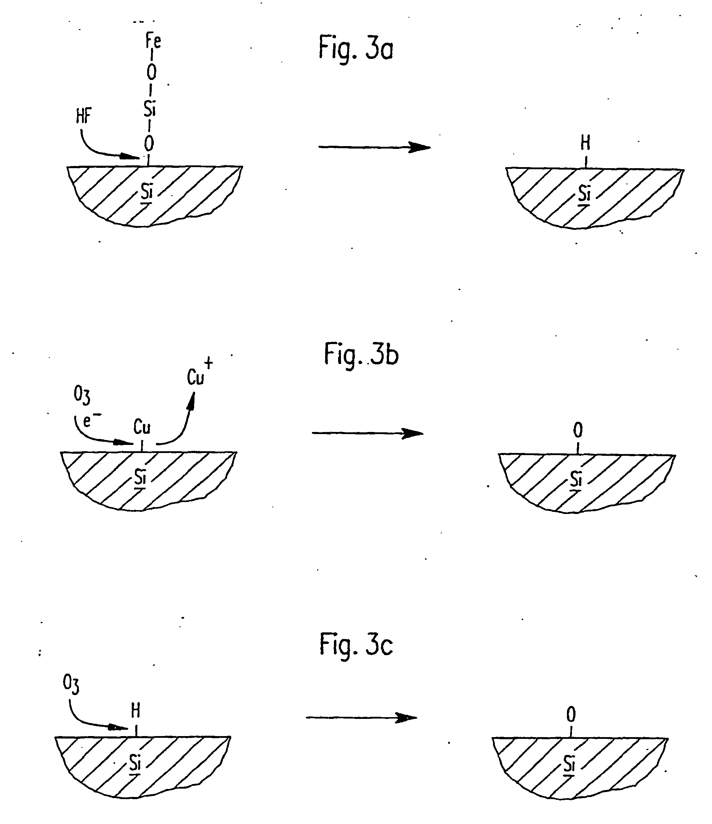

Fig. 3a shows that the HF solution in the aqueous solution guarantees the eroding of the silicon oxide layers into which metal ions like Fe may be embedded. Metal contamination like Cu, which are directly connected to an Si atom, are removed by a Redox process, as shown in Fig. 3b.

Fig. 3c shows how the ozone causes the silicon surface to oxidize.

Thus, the silicon leaves the drying bath perfectly clean, hydrophilic and dry.

Other embodiments of the invention will be apparent to one of ordinary skill in the art. Although the preferred embodiments and examples describe the drying of silicon wafers, the invention is applicable to substrates of many materials in addition to silicon, such as metals, plastics, glasses, and ceramics. The term "substrate" is not limited to substrates that support electronic circuitry, but applies to any object supporting a surface, i. e. having any adequate physical form, such as the form of wafers, plates or discs. The invention is not limited to the specific examples and is defined by the following claims.

## Claims

1. A method of drying a substrate surface (1), the substrate comprising silicon, comprising:
dipping the substrate into a liquid bath (2) comprising an aqueous HF solution (3), separating the substrate from the liquid bath (2), the substrate surface being hydrophobic upon separation from the liquid bath,
**characterized in**
**that** the substrate is separated from the bath, whereby the relative speed of separation between the substrate (1) and the surface of the aqueous HF solution (3) is between 0.1 cm/sec and 20 cm/sec, permitting the bath liquid to drain from the hydrophobic surface of the substrate to produce a dry substrate; and that a gas comprising an O₂/O₃ mixture that forms a hydrophilic surface on the substrate is directed over the surface of the dry substrate (1) after separating the substrate (1) from the liquid bath.

2. The method according to claim 1,
**characterized in,**
**that** the relative speed of separation between the substrate (1) and the surface of the aqueous HF solution (3) is between 0.5 cm/sec and 3.0 cm/sec.

3. The method according to claim lor 2,
**characterized in,**
**that** the liquid of the liquid bath (2) comprises an aqueous HF solution (3) with a concentration between .001% and 50%.

4. The method according to claim 3,
**characterized in,**
**that** the HF concentration in the aqueous solution is between .01% and 0.1%.

5. The method according to one of the claims 1 to 4,
**characterized in,**
**that** the substrate comprises a laser disk.

6. The method according to anyone of claims 1 to 5,
**characterized in,**
**that** the substrate (1) and the liquid bath (3) are separated by lifting the substrate out of the liquid bath.

7. The method according to anyone of claims 1 to 6,
**characterized in,**
**that** the substrate (1) and the liquid bath are separated by draining the liquid from the bath (2).

8. The method according to anyone of the preceding claims,
**characterized in,**
**that** the liquid bath (3) contains at least one additive selected from the group consisting of acids, organic acids, surfactants and solid additives.

9. The method of claim 8,
**characterized in,**
**that** said at least one additive is an acid selected from the group consisting of HCl, H₃PO₄, H₂SO₄, HClO, HClO₂, HClO₃ and HClO₄.

10. The method of claim 8,
**characterized in,**
**that** said aqueous solution contains a mixture of acids selected from the group consisting of HCl/H₂PO₄, H₃PO₄/HCl, H₃PO₄/H₂SO₄ and H₃PO₄/HCl/H₂SO₄.

11. The method of anyone of claims 8 to 10,
**characterized in,**
**that** said acid is added to give a concentration of up to 50% by weight.

12. The method of claim 8,
**characterized in,**
**that** said at least one additive is an organic acid selected from the group consisting of formic acid, acetic acid and citric acid.

13. The method of claim 12,
**characterized in,**
**that** said organic acid is added to give a final concentration of up to 80% by weight.

14. The method of claim 8,
**characterized in,**
**that** said surfactant is added to give a final concentration of up to 5% by weight.

15. The method of claim 8,
**characterized in,**
**that** said solid additive is NH₄F.

16. The method of claim 8,
**characterized in,**
**that** said solid additive is added to give a final concentration of up to 50% by weight.

17. The method according to anyone of claims 1 to 20,
**characterized in,**
**that** the method is carried out at a temperature between 0 and 100 degrees Celsius.

18. The method according to claim 21,
**characterized in,**
**that** the method is carried out at a temperature between 20 and 50 degrees Celsius.

19. The method according to anyone of the preceding claims,
**characterized in,**
**that** the proportion of O₃ in the O₂/O₃ gas mixture is between 1 mg and 0.5 g per liter of O₂/O₃ gas mixture.

## Patentansprüche

1. Verfahren zum Trocknen einer Substratoberfläche (1), wobei das Substrat Silizium umfasst, umfassend:
Eintauchen des Substrats in ein Flüssigkeitsbad (2), das eine wässrige HF-Lösung (3) umfasst, Trennen des Substrats vom Flüssigkeitsbad (2), wobei die Substratoberfläche bei der Trennung vom Flüssigkeitsbad hydrophob ist,
**dadurch gekennzeichnet, dass**
das Substrat vom Bad getrennt wird, wobei die relative Geschwindigkeit der Trennung zwischen dem Substrat (1) und der Oberfläche der wässrigen HF-Lösung (3) zwischen 0,1 cm/s und 20 cm/s liegt, was dem Bad gestattet, von der hydrophoben Oberfläche des Substrats abzulaufen, um ein trockenes Substrat zu erzeugen; und dass ein Gas, das eine O₂/O₃-Mischung umfasst, die eine hydrophile Oberfläche auf dem Substrat bildet, nach Trennung des Substrats (1) vom Flüssigkeitsbad über die Oberfläche des trockenen Substrats (1) geleitet wird.

2. Verfahren gemäß Anspruch 1, **dadurch gekennzeichnet, dass** die Relativgeschwindigkeit der Trennung zwischen dem Substrat (1) und der Oberfläche der wässrigen HF-Lösung (3) zwischen 0,5 cm/s und 3,0 cm/s liegt.

3. Verfahren gemäß Anspruch 1 oder 2, **dadurch gekennzeichnet, dass** die Flüssigkeit des Flüssigbads (2) eine wässrige HF-Lösung (3) mit einer Konzentration zwischen 0,001 % und 50 % umfasst.

4. Verfahren gemäß Anspruch 3, **dadurch gekennzeichnet, dass** die HF-Konzentration in der wässrigen Lösung zwischen 0,01 % und 0,1 % liegt.

5. Verfahren gemäß einem der Ansprüche 1 bis 4, **dadurch gekennzeichnet, dass** das Substrat eine "Laser-Disk" umfasst.

6. Verfahren gemäß einem der Ansprüche 1 bis 5, **dadurch gekennzeichnet, dass** das Substrat (1) und das Flüssigkeitsbad (3) durch Anheben des Substrats aus dem Flüssigkeitsbad getrennt werden.

7. Verfahren gemäß einem der Ansprüche 1 bis 6, **dadurch gekennzeichnet, dass** das Substrat (1) und das Flüssigkeitsbad (3) durch Ablaufenlassen der Flüssigkeit aus dem Bad (2) getrennt werden.

8. Verfahren gemäß einem der vorstehenden Ansprüche, **dadurch gekennzeichnet, dass** das Flüssigkeitsbad (3) zumindest einen Zusatzstoff enthält, der ausgewählt ist aus der Gruppe, die aus Säuren, organischen Säuren, grenzflächenaktiven Stoffen und festen Zusatzstoffen besteht.

9. Verfahren gemäß Anspruch 8, **dadurch gekennzeichnet, dass** der zumindest eine Zusatzstoff eine Säure ist, die ausgewählt ist aus der Gruppe, die aus HCl, H₃PO₄, H₂SO₄, HClO, HClO₂, HClO₃ und HClO₄ besteht.

10. Verfahren gemäß Anspruch 8, **dadurch gekennzeichnet, dass** die wässrige Lösung eine Mischung von Säuren enthält, die ausgewählt ist aus der Gruppe, die aus HCl/H₂PO₄, H₃PO₄/HCl, H₃PO₄/H₂SO₄ und H₃PO₄/HCl/H₂SO₄ besteht.

11. Verfahren gemäß einem der Ansprüche 8 bis 10, **dadurch gekennzeichnet, dass** die Säure derart zugegeben wird, dass sich eine Konzentration von bis zu 50 Gew.-% ergibt.

12. Verfahren gemäß Anspruch 8, **dadurch gekennzeichnet, dass** der zumindest eine Zusatzstoff eine organische Säure ist, die ausgewählt ist aus der Gruppe, die aus Ameisensäure, Essigsäure und Zitronensäure besteht.

13. Verfahren gemäß Anspruch 12, **dadurch gekennzeichnet, dass** die organische Säure derart zugegeben wird, dass sich eine Endkonzentration von bis zu 80 Gew.-% ergibt.

14. Verfahren gemäß Anspruch 8, **dadurch gekennzeichnet, dass** der grenzflächenaktive Stoff derart zugegeben wird, dass sich eine Endkonzentration von bis zu 5 Gew.-% ergibt.

15. Verfahren gemäß Anspruch 8, **dadurch gekennzeichnet, dass** der feste Zusatzstoff NH₄F ist.

16. Verfahren gemäß Anspruch 8, **dadurch gekennzeichnet, dass** der feste Zusatzstoff derart zugegeben wird, dass sich eine Endkonzentration von bis zu 50 Gew.-% ergibt.

17. Verfahren gemäß einem der Ansprüche 1 bis 20, **dadurch gekennzeichnet, dass** das Verfahren bei einer Temperatur zwischen 0 und 100°C ausgeführt wird.

18. Verfahren gemäß Anspruch 21, **dadurch gekennzeichnet, dass** das Verfahren bei einer Temperatur zwischen 20 und 50°C ausgeführt wird.

19. Verfahren gemäß einem der vorstehenden Ansprüche, **dadurch gekennzeichnet, dass** der Anteil von O₃ in der O₂/O₃-Gasmischung zwischen 1 mg und 0,5 g pro Liter der O₂/O₃-Gasmischung beträgt.

## Revendications

1. Procédé pour sécher une surface de substrat (1), le substrat comprenant du silicium, comprenant :
l'immersion du substrat dans un bain de liquide (2) comprenant une solution aqueuse de HF (3), la séparation du substrat d'avec le bain de liquide (2), la surface du substrat étant hydrophobe lors de la séparation d'avec le bain de liquide,
**caractérisé en ce que** le substrat est séparé du bain, en conséquence de quoi la vitesse relative de séparation entre le substrat (1) et la surface de la solution aqueuse de HF (3) est comprise entre 0,1 cm/s et 20 cm/s, permettant au liquide du bain d'être drainé à partir de la surface hydrophobe du substrat pour produire un substrat sec ; et **en ce qu'**un gaz comprenant un mélange O₂/O₃ qui forme une surface hydrophile sur le substrat est dirigé au-dessus de la surface du substrat sec (1) après séparation du substrat (1) d'avec le bain de liquide.

2. Procédé selon la revendication 1, **caractérisé en ce que** la vitesse relative de séparation entre le substrat (1) et la surface de la solution aqueuse de HF (3) est comprise entre 0,5 cm/s et 3,0 cm/s.

3. Procédé selon la revendication 2, **caractérisé en ce que** le liquide du bain de liquide (2) comprend une solution aqueuse de HF (3) ayant une concentration comprise entre 0,001 % et 50 %.

4. Procédé selon la revendication 3, **caractérisé en ce que** la concentration de HF dans la solution aqueuse est comprise entre 0,01 % et 0,1 %.

5. Procédé selon l'une quelconque des revendications 1 à 4, **caractérisé en ce que** le substrat comprend un disque laser.

6. Procédé selon l'une quelconque des revendications 1 à 5, **caractérisé en ce que** le substrat (1) et le bain de liquide (3) sont séparés par soulèvement du substrat hors du bain de liquide.

7. Procédé selon l'une quelconque des revendications 1 à 6, **caractérisé en ce que** le substrat (1) et le bain de liquide sont séparés par drainage du liquide à partir du bain (2).

8. Procédé selon l'une quelconque des revendications précédentes, **caractérisé en ce que** le bain de liquide (3) contient au moins un additif choisi dans le groupe constitué par les acides, les acides organiques, les tensioactifs et les additifs solides.

9. Procédé selon la revendication 8, **caractérisé en ce que** ledit au moins un additif est un acide choisi dans le groupe constitué par HCl, H₃PO₄, H₂SO₄, HClO, HClO₂, HClO₃ et HClO₄.

10. Procédé selon la revendication 8, **caractérisé en ce que** ladite solution aqueuse contient un mélange d'acides choisi dans le groupe constitué par HCl/H₂PO₄, H₃PO₄/HCl, H₃PO₄/H₂SO₄ et H₃PO₄/HCl/H₂SO₄.

11. Procédé selon l'une quelconque des revendications 8 à 10, **caractérisé en ce que** ledit acide est ajouté pour atteindre une concentration allant jusqu'à 50 % en poids.

12. Procédé selon la revendication 8, **caractérisé en ce qu'**au moins un additif est un acide organique choisi dans le groupe constitué par l'acide formique, l'acide acétique et l'acide citrique.

13. Procédé selon la revendication 12, **caractérisé en ce que** ledit acide organique est ajouté pour atteindre une concentration finale allant jusqu'à 80 % en poids.

14. Procédé selon la revendication 8, **caractérisé en ce que** ledit tensioactif est ajouté pour atteindre une concentration finale allant jusqu'à 5 % en poids.

15. Procédé selon la revendication 8, **caractérisé en ce que** ledit additif solide est NH₄F.

16. Procédé selon la revendication 8, **caractérisé en ce que** ledit additif solide est ajouté pour atteindre une concentration finale allant jusqu'à 50 % en poids.

17. Procédé selon l'une quelconque des revendications 1 à 20, **caractérisé en ce que** le procédé est mis en oeuvre à une température comprise entre 0 et 100°C.

18. Procédé selon la revendication 21, **caractérisé en ce que** le procédé est mis en oeuvre à une température comprise entre 20 et 50°C.

19. Procédé selon l'une quelconque des revendications précédentes, **caractérisé en ce que** la proportion de O₃ dans le mélange gazeux O₂/O₃ est comprise entre 1 mg et 0,5 g par litre de mélange gazeux O₂/O₃.
